# EUROPEAN PATENT APPLICATION

(11) **EP 4 050 132 A1**
(43) Date of publication of application: **31.08.2022**
(21) Application number: 20879022.0
(22) Date of filing: 08.10.2020
(51) Int. Cl.: C30B 25/18, H01L 21/20, H01L 21/205, H01L 21/31, H01L 21/318, H01L 27/12, C30B 29/38

(54) **SEMICONDUCTOR SUBSTRATE MANUFACTURING METHOD AND SEMICONDUCTOR SUBSTRATE**

(30) Priority: 24.10.2019 JP 2019193547
(71) Applicant: Shin-Etsu Handotai Co., Ltd., Tokyo 100-0004 (JP)
(72) Inventor: NIITANI, Miho, Chikuma-shi, Nagano 387-8555 (JP); WAKABAYASHI, Taishi, Chikuma-shi, Nagano 387-8555 (JP); YAMADA, Kento, Chikuma-shi, Nagano 387-8555 (JP); YOSHIDA, Kazuhiko, Chikuma-shi, Nagano 387-8555 (JP)
(74) Representative: Sonnenhauser, Thomas Martin
(86) International application number: PCT/JP2020/038088
(87) International publication number: WO 2021/079745

(57) **Abstract**

The present invention is a method for manufacturing a semiconductor substrate by forming an insulator film and a semiconductor single crystal layer successively on a surface of a silicon single crystal substrate to manufacture a semiconductor substrate having the semiconductor single crystal layer on the insulator film, the method including at least the steps of: forming a silicon nitride film having an epitaxial relationship with the silicon single crystal substrate on the surface of the silicon single crystal substrate as the insulator film by subjecting the silicon single crystal substrate to a heat treatment under a nitrogen gas-containing atmosphere; and forming the semiconductor single crystal layer on the silicon nitride film by epitaxial growth. This provides a method for manufacturing a semiconductor substrate and a semiconductor substrate that make it possible to obtain a semiconductor substrate by a simple method with high productivity at low cost even when the insulator film provided between the silicon single crystal substrate and the semiconductor single crystal layer is a silicon nitride film.

## Description

### TECHNICAL FIELD

The present invention relates to: a method for manufacturing a semiconductor substrate having a semiconductor single crystal layer on an insulator film, such as an SOI (Silicon On Insulator) substrate; and a semiconductor substrate.

### BACKGROUND ART

Examples of semiconductor substrates for semiconductor devices include an SOI (Silicon On Insulator) substrate having a silicon layer formed on a silicon oxide film (hereinafter, sometimes referred to as an SOI layer), which is an insulator film. This SOI substrate has characteristics such as a small parasitic capacitance or high radiation hardness ability since the SOI layer of a substrate surface layer portion which is to be a device fabrication region is electrically separated from the inside of the substrate by a buried oxide film layer (BOX layer). Thus, effects such as a high-speed low-consumption-power operation or soft error prevention are expected, and this substrate is regarded as a viable high-performance semiconductor device substrate.

Examples of typical methods for manufacturing such an SOI substrate include a wafer bonding method and a SIMOX method. The wafer bonding method is, for example, a method for manufacturing an SOI substrate in the following manner. A thermal oxide film is formed on a surface of one of two single crystal silicon substrates (silicon wafers). Then, the two wafers are adhered to one another via the formed thermal oxide film, and a bonding heat treatment is performed in order to enhance bonding strength. After that, one of the wafers (the wafer that forms the SOI layer (hereinafter, bond wafer)) is thinned by mirror-polishing or the like. Methods of this thinning include: a method of grinding and polishing the bond wafer to a desired thickness; a method called an ion implantation delamination method, which includes forming an ion implanted layer by implanting at least one kind out of a hydrogen ion or rare gas ions into a bond wafer in advance, and then delaminating the bond wafer at the ion implanted layer after the bonding; and the like. The SIMOX method is a method for manufacturing an SOI substrate by ion-implanting oxygen into a single crystal silicon substrate, and then forming a BOX layer by performing a high-temperature heat treatment (an oxide-film-forming heat treatment) to make the implanted oxygen and silicon react.

Patent Documents 1 and 2 disclose forming an oxide film having an epitaxial relationship with a silicon single crystal substrate on a surface of the silicon single crystal substrate and depositing an epitaxial layer on the oxide film to fabricate an SOI wafer. Meanwhile, in Patent Document 3, it is disclosed that a silicon nitride film can be used as a buried insulator film in a method for manufacturing an SOI wafer by an ion implantation delamination method.

### CITATION LIST

### PATENT LITERATURE

Patent Document 1: JP 5168990 B2
Patent Document 2: JP 5205840 B2
Patent Document 3: WO 2004/010505 A1

### SUMMARY OF INVENTION

### TECHNICAL PROBLEM

Methods for manufacturing an SOI wafer include a bonding method as described above, but there are problems that material costs arise since two wafers are bonded together, and that the number of steps in manufacturing is great. In the SIMOX method, too, there is a problem that there are many manufacturing steps such as ion implantation and high-temperature heat treatment. In view of the quality of the SOI layer and BOX layer to be formed and the degree of freedom and uniformity of the film thickness, the ion implantation delamination method is the most promising among the above-described methods for manufacturing an SOI substrate. However, in order to obtain an SOI layer having a thickness of 10 nm, for example, it is necessary to adjust the film thickness by forming an SOI layer thicker than that, and then perform a sacrificial oxidation treatment. Therefore, the process becomes complicated, and high costs cannot be avoided.

The silicon nitride film as an insulator film disclosed in Patent Document 3 has a large dielectric constant compared with a silicon oxide film, and therefore, has an advantage that the silicon nitride film functions as a buried insulator film of an SOI wafer at a thin film thickness. However, Patent Documents 1 and 2 do not disclose or suggest forming a silicon nitride film as a buried insulator film. No method has been known which makes it possible to obtain an SOI substrate by a simple method with high productivity when forming a silicon nitride film as a buried insulator film.

The present invention has been made to solve the above problems. An object of the present invention is to provide: a method for manufacturing a semiconductor substrate such as an SOI substrate having an insulator film and a semiconductor single crystal layer on the insulator film on a surface of a silicon single crystal substrate by which a semiconductor substrate can be obtained by a simple method with high productivity at low cost, even when the insulator film provided between the silicon single crystal substrate and the semiconductor single crystal layer is a silicon nitride film; and a semiconductor substrate.

### SOLUTION TO PROBLEM

The present invention has been made to achieve the object, and provides a method for manufacturing a semiconductor substrate by forming an insulator film and a semiconductor single crystal layer successively on a surface of a silicon single crystal substrate to manufacture a semiconductor substrate having the semiconductor single crystal layer on the insulator film, the method comprising at least the steps of:
forming a silicon nitride film having an epitaxial relationship with the silicon single crystal substrate on the surface of the silicon single crystal substrate as the insulator film by subjecting the silicon single crystal substrate to a heat treatment under a nitrogen gas-containing atmosphere; and
forming the semiconductor single crystal layer on the silicon nitride film by epitaxial growth.

According to such a method for manufacturing a semiconductor substrate, a semiconductor substrate can be provided by a simple method with high productivity at low cost.

In this event, the method can be a method for manufacturing a semiconductor substrate where the heat treatment under the nitrogen gas-containing atmosphere is performed at a temperature of 800°C or higher.

In this manner, a silicon nitride film can be formed more stably and certainly without losing productivity.

In this event, the method can be a method for manufacturing a semiconductor substrate where by using an epitaxial growth apparatus as an apparatus for performing the heat treatment, the silicon nitride film is formed, and then an atmospheric gas inside the epitaxial growth apparatus is switched to a gas for growing the semiconductor single crystal layer to perform the epitaxial growth.

In this manner, a high-quality semiconductor substrate can be obtained by an extremely simple method more efficiently with higher productivity at lower cost.

In this event, the method can be a method for manufacturing a semiconductor substrate where the semiconductor single crystal layer is one of an Si layer, an SiGe layer, a Ge layer, or a compound semiconductor layer.

In this manner, it is possible to obtain a semiconductor substrate having a better-quality semiconductor single crystal layer.

In this event, the method can be a method for manufacturing a semiconductor substrate where the semiconductor single crystal layer is an Si layer, and a gas for the epitaxial growth of the Si layer is trichlorosilane.

In this manner, an SOI semiconductor substrate can be obtained with higher productivity at lower cost.

In this event, the method can be a method for manufacturing a semiconductor substrate where the silicon nitride film has a film thickness of 2 nm or less.

In this manner, a silicon nitride film having an epitaxial relationship with the underlying silicon single crystal substrate can be obtained more stably and certainly.

In this event, the method can be a method for manufacturing a semiconductor substrate where a plurality of layers of the silicon nitride film and the semiconductor single crystal layer are formed alternately.

In this manner, it is also possible to adjust the dielectric breakdown strength between the silicon single crystal substrate and the uppermost semiconductor single crystal layer needed in total. Similarly, by laminating a plurality of the layers alternately, it is also possible to form a stacked structure of a vertical multilayer memory, a three-dimensional stacked integrated circuit, etc.

In this event, the method can be a method for manufacturing a semiconductor substrate where a silicon single crystal substrate doped with nitrogen or oxygen beforehand is used as the silicon single crystal substrate.

In this manner, the silicon nitride layer itself, a silicon oxynitride layer or a silicon oxide layer is additionally formed by the thermal history of the formation of the silicon nitride film and the subsequent formation of the semiconductor crystal layer, and the subsequent additional thermal history. Thus, the initially formed thickness of the silicon nitride layer can be thickened.

In this event, the method can be a method for manufacturing a semiconductor substrate where a silicon single crystal substrate having a plane orientation of (111) is used as the silicon single crystal substrate.

The surface structure of a silicon single crystal substrate having a plane orientation of (111) is similar to the atomic structure of a silicon nitride film (Si₃N₄), and can therefore be used suitably for forming a silicon nitride film having an epitaxial relationship with a silicon single crystal substrate. This makes it possible to obtain a silicon nitride film having an epitaxial relationship with the underlying silicon single crystal substrate with more stability and certainty.

In addition, the present invention provides a semiconductor substrate having an insulator film and a semiconductor single crystal layer on the insulator film on a surface of a silicon single crystal substrate, wherein
the insulator film is a silicon nitride film having an epitaxial relationship with the silicon single crystal substrate and
the semiconductor single crystal layer is an epitaxial growth layer.

Such a semiconductor substrate has a high-quality semiconductor single crystal layer that can be obtained simply and at low cost.

In this event, the semiconductor substrate can be a semiconductor substrate in which the semiconductor single crystal layer is one of an Si layer, an SiGe layer, a Ge layer, or a compound semiconductor layer.

This gives a better-quality semiconductor single crystal layer.

In this event, the silicon nitride film of the semiconductor substrate can have a film thickness of 2 nm or less.

This allows a silicon nitride film having an epitaxial relationship with the underlying silicon single crystal substrate more stably and certainly.

In this event, the semiconductor substrate can have a plurality of layers of the silicon nitride film and the semiconductor single crystal layer alternately.

This makes it possible to adjust the dielectric breakdown strength needed in total between the silicon single crystal substrate and the uppermost semiconductor single crystal layer. In addition, a stacked structure of a vertical multilayer memory, a three-dimensional stacked integrated circuit, and so forth can also be formed with the semiconductor substrate.

In this event, the silicon single crystal substrate of the semiconductor substrate can have a plane orientation of (111).

This provides a silicon nitride film having an epitaxial relationship with the underlying silicon single crystal substrate with more stability and certainty.

### ADVANTAGEOUS EFFECTS OF INVENTION

As described above, according to the inventive method for manufacturing a semiconductor substrate, it is possible to provide a semiconductor substrate having a silicon nitride film as an insulator film and a high-quality semiconductor single crystal layer simply and at low cost.

### BRIEF DESCRIPTION OF DRAWINGS

FIG. 1 shows a conceptual diagram of a semiconductor substrate according to the present invention along with a manufacturing flow.
FIG. 2 shows a cross-sectional TEM observation photograph of an SOI wafer (semiconductor substrate) of Example 1.
FIG. 3 shows a partial enlarged view (lattice image) of FIG. 2.
FIG. 4 shows a cross-sectional TEM observation photograph of an SOI wafer (semiconductor substrate) of Example 2.
FIG. 5 shows a partial enlarged view (lattice image) of FIG. 4.

### DESCRIPTION OF EMBODIMENTS

Hereinafter, the present invention will be described in detail, but the present invention is not limited thereto.

As described above, a method for manufacturing a semiconductor substrate and a semiconductor substrate have been desired that make it possible to obtain a semiconductor substrate by a simple method with high productivity even when an insulator film provided between a silicon single crystal substrate and a semiconductor single crystal layer is a silicon nitride film.

The present inventors have earnestly studied the problem and found out that when a silicon single crystal substrate is subjected to a heat treatment (thermal nitridation) under a nitrogen gas-containing atmosphere, the silicon nitride film formed on a surface of the silicon single crystal substrate has an epitaxial relationship with the underlying silicon single crystal substrate. Furthermore, the present inventors have conceived that such a silicon nitride film enables a semiconductor single crystal layer to be formed by epitaxial growth on a surface of the film, and completed the present invention.

That is, the present inventors have found out that it is possible to provide a semiconductor substrate having a silicon nitride film as an insulator film and a high-quality semiconductor single crystal layer simply and at low cost by a method for manufacturing a semiconductor substrate by forming an insulator film and a semiconductor single crystal layer successively on a surface of a silicon single crystal substrate to manufacture a semiconductor substrate having the semiconductor single crystal layer on the insulator film, the method including at least the steps of:
forming a silicon nitride film having an epitaxial relationship with the silicon single crystal substrate on the surface of the silicon single crystal substrate as the insulator film by subjecting the silicon single crystal substrate to a heat treatment under a nitrogen gas-containing atmosphere; and
forming the semiconductor single crystal layer on the silicon nitride film by epitaxial growth. Thus, the present invention has been completed.

The present inventors have also found out that it is possible to achieve a semiconductor substrate having a silicon nitride film as an insulator film and a high-quality semiconductor single crystal layer and that can be obtained by a low-cost and simple method by providing a semiconductor substrate having an insulator film and a semiconductor single crystal layer on the insulator film on a surface of a silicon single crystal substrate, wherein
the insulator film is a silicon nitride film having an epitaxial relationship with the silicon single crystal substrate and
the semiconductor single crystal layer is an epitaxial growth layer. Thus, the present invention has been completed.

Hereinafter, a description will be given with reference to the drawings.

In the present invention, a "silicon nitride film having an epitaxial relationship" means a silicon nitride film having crystallinity at a level that allows the epitaxial growth of a semiconductor single crystal layer such as a single crystal Si layer.

### (Semiconductor Substrate)

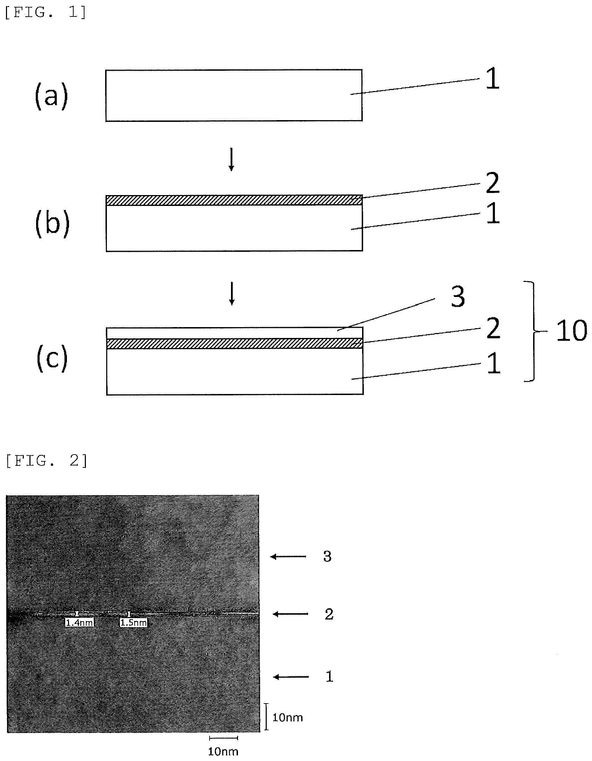

Firstly, the semiconductor substrate according to the present invention will be described. FIG. 1 (c) shows the inventive semiconductor substrate 10. The inventive semiconductor substrate 10 has at least a silicon nitride film 2 having an epitaxial relationship as an insulator film and a semiconductor single crystal layer 3 on the silicon nitride film 2 on a surface of a silicon single crystal substrate 1.

The silicon single crystal substrate 1 is not particularly limited as long as it is a silicon single crystal, and the orientation of the surface, resistivity of the substrate, conductivity type (p or n), type of dopant, diameter (area), thickness, etc. can be appropriately selected and set according to usage. The silicon single crystal substrate 1 can be an FZ substrate or a CZ substrate, and physical properties such as the oxygen concentration in the crystal are not particularly limited either.

The silicon single crystal substrate 1 preferably has a plane orientation of (111). The surface structure of a silicon single crystal substrate having a plane orientation of (111) is similar to the atomic structure of a silicon nitride film (Si₃N₄). Therefore, such a silicon single crystal substrate can be used suitably for forming a silicon nitride film having an epitaxial relationship with the silicon single crystal substrate.

In addition, in the inventive semiconductor substrate, when a thin silicon nitride film of 2 nm or less, for example, is provided over a wide range (for example, the entire surface of the wafer), the silicon nitride film on the silicon single crystal substrate needs to have high uniformity. In this case, it is preferable to use, as the silicon single crystal substrate, a wafer obtained by subjecting a silicon single crystal substrate to an annealing treatment beforehand or a wafer obtained by providing a silicon single crystal substrate with an epitaxial silicon layer beforehand. The surface flatness of the wafer is improved by the annealing treatment or epitaxial growth, and a silicon nitride film 2 having higher uniformity can be achieved.

In addition, the plane orientation of the silicon single crystal substrate 1 can be given an off-angle to introduce an atomic step. Thus, it is possible to increase the step growth rate of the silicon nitride film and improve the uniformity of the silicon nitride film. Similarly, when the whole silicon single crystal substrate or a surface thereof has a high-concentration dopant or a high concentration of oxygen or a silicon precipitate thereof, it is also possible to increase the step growth rate of the silicon nitride film by the influence of distortion, the reaction of the dopant, oxygen, or precipitate, or the like and achieve a silicon nitride film 2 having high uniformity.

Although details of a manufacturing method will be described later, the silicon nitride film 2 is formed by the nitridation of silicon by a heat treatment in a nitrogen gas-containing atmosphere, and is a "silicon nitride film having an epitaxial relationship" with the silicon single crystal substrate 1.

Such a silicon nitride film 2 preferably has a film thickness of 2 nm or less, since the thinner the film thickness, the more stably the silicon nitride film 2 sustains the epitaxial relationship with the underlying silicon single crystal substrate 1.

In addition, a silicon nitride film has a higher etching resistance property to high-temperature gas than a silicon oxide film. Therefore, it is possible to use trichlorosilane as an Si source when forming an Si layer by epitaxial growth as a semiconductor single crystal layer 3 described below. In the above-described Patent Documents 1 and 2, a monosilane gas is used as a source gas when forming a Si single crystal layer by epitaxial growth. However, when the insulator film is a silicon nitride film as in the inventive semiconductor substrate 10, it is possible to use trichlorosilane, which is less expensive than monosilane and has a high growth rate, when forming a semiconductor single crystal layer 3 of a Si layer on the insulator film by epitaxial growth. Thus, advantages can be obtained regarding cost in mass production.

The semiconductor single crystal layer 3 is an epitaxial growth layer. This semiconductor single crystal layer 3 functions as a so-called SOI layer in an SOI wafer. The semiconductor single crystal layer 3 is preferably an Si layer, which has the same material as the underlying silicon single crystal substrate 1. However, the semiconductor single crystal layer 3 is not limited to an Si layer, and any semiconductor single crystal layer 3 having a lattice constant close to that of the silicon single crystal can be formed by epitaxial growth. Specific examples include an SiGe layer, a Ge layer, a compound semiconductor layer (such as a GaN layer or an AlN layer), etc. Such layers make it possible to obtain a semiconductor single crystal layer of better quality. Note that the film thickness of the semiconductor single crystal layer 3 is not particularly limited, and can be appropriately determined in accordance with the design of the device to be applied to.

Furthermore, the inventive semiconductor substrate can also have a plurality of layers of the silicon nitride film 2 and the semiconductor single crystal layer 3 alternately. The dielectric breakdown strength that one layer of the silicon nitride film 2 of 2 nm or less has can be adjusted to the dielectric breakdown strength between the silicon single crystal substrate and the uppermost semiconductor single crystal layer needed in total by the structure having the plurality of layers of the silicon nitride film 2 and the semiconductor single crystal layer 3 laminated alternately. Similarly, by laminating a plurality of layers alternately, a stacked structure of a vertical multilayer memory, a three-dimensional stacked integrated circuit, etc. can also be formed.

### (Method for Manufacturing Semiconductor Substrate)

Next, the inventive method for manufacturing a semiconductor substrate will be described with reference to FIG. 1.

Firstly, as shown in FIG. 1 (a), a silicon single crystal substrate 1 for forming a silicon nitride film 2 and a semiconductor single crystal layer 3 successively on a surface thereof is prepared.

At this time, it is also possible to use a silicon single crystal substrate 1 doped with nitrogen or oxygen in advance. When such a silicon single crystal substrate 1 is used, the silicon nitride layer itself, a silicon oxynitride layer or a silicon oxide layer is additionally formed by the thermal history of the formation of the silicon nitride film 2 and the subsequent formation of the semiconductor single crystal layer 3, and the subsequent additional thermal history. Thus, the initially formed thickness of the silicon nitride film 2 can be thickened.

Furthermore, as described above, a silicon single crystal substrate having a plane orientation of (111) is preferably used as the silicon single crystal substrate.

Furthermore, in order to form a thin silicon nitride film of 2 nm or less, for example, over a wide range (for example, the entire surface of the wafer), it is necessary to raise the uniformity of the silicon nitride film to be formed on the silicon single crystal substrate. By subjecting the silicon single crystal substrate to an annealing treatment or forming a silicon layer on the silicon single crystal substrate by epitaxial growth beforehand, the surface flatness of the wafer can be improved, so that the uniformity of the silicon nitride film to be formed on the substrate can be improved. In addition, it is possible to increase the step growth rate of the silicon nitride film and improve the uniformity of the silicon nitride film by using a wafer obtained by providing the plane orientation of the silicon single crystal substrate with an off-angle to introduce an atomic step or a wafer having a high-concentration dopant, a high concentration of oxygen, or a silicon precipitate thereof on the entire silicon single crystal substrate or a surface thereof.

Next, a silicon nitride film 2 is formed on a surface of the silicon single crystal substrate 1 in the following manner. Firstly, the prepared silicon single crystal substrate 1 is introduced into a heat treatment furnace. Subsequently, as shown in FIG. 1 (b), a "silicon nitride film 2 having an epitaxial relationship" with the silicon single crystal substrate 1 is formed on the surface of the silicon single crystal substrate 1. The "silicon nitride film 2 having an epitaxial relationship" can be formed by performing a heat treatment in a nitrogen gas-containing atmosphere. Specifically, for example, a silicon nitride film 2 having an epitaxial relationship can be obtained by performing a heat treatment in a mixed gas atmosphere of a nitrogen gas and a hydrogen gas. In this event, when the mixed proportion of the nitrogen gas is low, the heat treatment temperature is preferably high (e.g. 1100°C or higher). However, when the mixed proportion of the nitrogen gas is raised, a temperature of about 800°C is also possible. A temperature of 800°C or higher is preferable since the silicon nitride film can be formed more stably and certainly without degrading productivity. The upper limit of the heat treatment temperature is not particularly limited, and theoretically, can be lower than the melting point of the silicon single crystal substrate 1. However, in view of productivity, thermal damage to the substrate, etc., the temperature can be set to about 1300°C or lower.

In addition, the thinner the film thickness of the silicon nitride film 2 formed, the more stably and certainly the silicon nitride film 2 can have an epitaxial relationship with the underlying silicon single crystal substrate 1. Therefore, the film thickness of the silicon nitride film 2 is preferably 2 nm or less. The lower limit of the film thickness of the silicon nitride film 2 is not particularly limited as long as the silicon nitride film 2 has the epitaxial relationship with the underlying silicon single crystal substrate 1, but can be 0.3 nm or more.

After forming the silicon nitride film 2, as shown in FIG. 1 (c), a semiconductor single crystal layer 3 is formed on the silicon nitride film 2 by epitaxial growth by using an epitaxial growth apparatus. Examples of the semiconductor single crystal layer 3 to be grown include an Si layer, an SiGe layer, a Ge layer, and a compound semiconductor layer (such as a GaN layer and an AlN layer) as described above.

Moreover, the formation of the silicon nitride film 2 and the semiconductor single crystal layer 3 can be repeated alternately to form a plurality of layers of the silicon nitride film 2 and the semiconductor single crystal layer 3 alternately. The dielectric breakdown strength that one layer of the silicon nitride film 2 of 2 nm or less has can be adjusted to the dielectric breakdown strength between the silicon single crystal substrate 1 and the uppermost semiconductor single crystal layer needed in total by the structure having the plurality of layers of the silicon nitride film 2 and the semiconductor single crystal layer 3 laminated alternately. Similarly, by laminating a plurality of layers alternately, a stacked structure of a vertical multilayer memory, a three-dimensional stacked integrated circuit, etc. can also be formed.

The conditions for the epitaxial growth of the semiconductor single crystal layer 3 and the source gas to be used can be appropriately set and selected in accordance with the type of the semiconductor single crystal layer 3 to be grown. The inventive semiconductor substrate 10 is provided with a silicon nitride film 2 as an insulator film. Since a silicon nitride film has a higher etching resistance property than a silicon oxide film regarding high-temperature gases, trichlorosilane can be used as a source gas when forming a semiconductor single crystal layer 3 containing Si such as an Si layer or an SiGe layer by epitaxial growth. In addition, since trichlorosilane is less expensive than monosilane and has a high growth rate, trichlorosilane is advantageous in that an advantage in cost can be obtained in mass production. Furthermore, trichlorosilane is a material that can be handled easily compared with monosilane and is highly safe, so that costs on manufacturing facilities can also be reduced.

In the above manner, it is possible to obtain a semiconductor substrate 10 having a silicon nitride film 2 that has an epitaxial relationship with the silicon single crystal substrate 1 as an insulator film and a semiconductor single crystal layer 3, which is an epitaxial growth layer on the insulator film, on a surface of a silicon single crystal substrate 1. According to such a method for manufacturing a semiconductor substrate, there is no need for two wafers as in the bonding method, so that material cost can be reduced. In addition, the number of manufacturing steps can also be reduced, the method is simple, and high productivity can be realized, so that the overall cost can be reduced.

In the above-described method for manufacturing the semiconductor substrate 10, the heat treatment apparatus for nitriding the surface of the silicon single crystal substrate 1 to form the silicon nitride film 2 is not particularly limited as long as the heat treatment apparatus can perform a heat treatment under a nitrogen gas-containing atmosphere and nitride the surface of the silicon single crystal substrate 1. For example, an RTP (Rapid Thermal Processing) apparatus using lamp heating or the like, a batch type resistance heating furnace, an epitaxial growth apparatus for performing epitaxial growth on a substrate, etc. can be used. In particular, an epitaxial growth apparatus is preferably used.

When an epitaxial growth apparatus is used, the semiconductor single crystal layer 3 can be formed by epitaxial growth by switching the atmospheric gas inside the furnace to a gas for the epitaxial growth of the semiconductor single crystal layer 3 after performing the heat treatment for nitriding inside the epitaxial growth apparatus to form the silicon nitride film 2 on the surface of the silicon single crystal substrate 1. In this manner, the growth of the silicon nitride film 2 and the epitaxial growth of the semiconductor single crystal layer 3 can be performed continuously inside the same furnace. Therefore the semiconductor substrate 10 can be manufactured by an extremely simple method efficiently with high productivity. Moreover, since the formation of the silicon nitride film 2 and the epitaxial growth of the semiconductor single crystal layer 3 can be performed in the same apparatus and contamination accompanying transfer between apparatuses does not occur, a high-quality semiconductor substrate 10 having a low contamination level can be obtained.

### EXAMPLE

Hereinafter, the present invention will be described in detail with reference to Examples, but the present invention is not limited thereto.

### (Example 1)

An SOI wafer (semiconductor substrate) having, on a surface of a silicon wafer (silicon single crystal substrate), a silicon nitride film (insulator film) having an epitaxial relationship with the silicon wafer and an Si epitaxial growth layer (semiconductor single crystal layer/SOI layer) on the silicon nitride film was fabricated, and the structure thereof was evaluated. The manufacturing conditions are as follows.

### (Features of SOI Wafer)

| | |
|---|---|
| Si wafer | : diameter of 200 mm, plane orientation of (100), |
| | p type, 10 Qcm |
| Insulator film : | silicon nitride |
| SOI layer | : Si epitaxial growth layer |

### (Manufacturing Conditions of SOI Wafer)

| | |
|---|---|
| Heat treatment apparatus | : single wafer processing epitaxial growth apparatus |
| Silicon nitride film | : N₂ 24 slm + H₂ 34 slm heat treatment temperature of 1190°C |
| | heat treatment time of 300 seconds |
| Si (SOI) layer | : trichlorosilane 10 slm + H₂ 34 slm |
| | growth temperature of 1070°C |
| | growth time of 600 seconds growth rate of 2.4 µm/min |

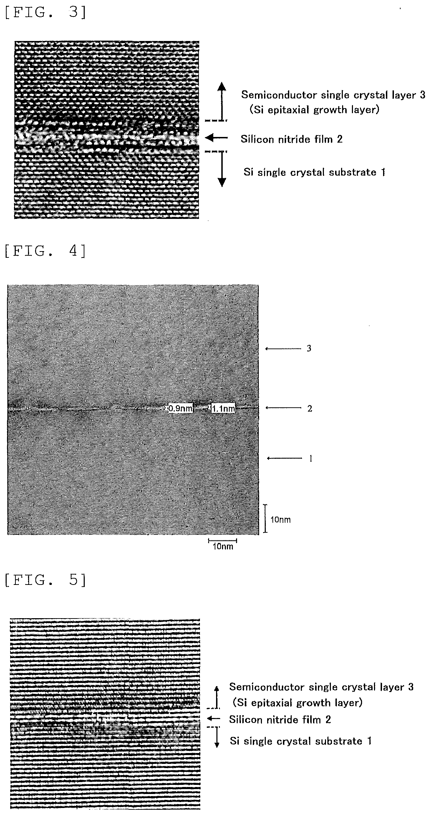

A cross section of the obtained SOI wafer was observed using a transmission electron microscope (TEM). FIG. 2 shows a cross-sectional TEM observation photograph of the SOI wafer (semiconductor substrate) manufactured in Example 1. FIG. 3 is a lattice image of FIG. 2 enlarged around the silicon nitride film. As shown in FIG. 2, it can be observed that a silicon nitride film of about 1.4 to 1.5 nm was formed between the Si wafer and the SOI layer (Si epitaxial growth layer). In addition, as shown in FIG. 3, it can be observed that a silicon nitride film (the lattice image observed in the silicon nitride film portion) having an epitaxial relationship with the Si wafer and an Si epitaxial growth layer formed on the silicon nitride film by epitaxial growth were formed on the surface of the Si wafer. Note that elements in the film were analyzed regarding the silicon nitride film portion by TEM-EDX, and as a result, it was confirmed that Si and N were detected.

### (Example 2)

### (Features of SOI Wafer)

| | |
|---|---|
| Si wafer | : diameter of 150 mm, plane orientation of (111), |
| | p type, 50 Ωcm |
| Insulator film : | silicon nitride |
| SOI layer | : Si epitaxial growth layer |

### (Manufacturing Conditions of SOI Wafer)

| | |
|---|---|
| Heat treatment apparatus | : single wafer processing epitaxial growth apparatus |
| Silicon nitride film | : N₂ 24 slm + H₂ 34 slm heat treatment temperature of 1190°C |
| | heat treatment time of 300 seconds |
| Si (SOI) layer | : trichlorosilane 10 slm + H₂ 34 slm |
| | growth temperature of 1130°C |
| | growth time of 15 seconds growth rate of 3.8 pm/min |

A cross section of the obtained SOI wafer was observed using a transmission electron microscope (TEM). FIG. 4 shows a cross-sectional TEM observation photograph of the SOI wafer (semiconductor substrate) manufactured in Example 2. FIG. 5 is a lattice image of FIG. 4 enlarged around the silicon nitride film. As shown in FIG. 4, it can be observed that a silicon nitride film of about 0.9 to 1.1 nm was formed between the Si wafer and the SOI layer (Si epitaxial growth layer). In addition, as shown in FIG. 5, it can be observed that a silicon nitride film (the lattice image observed in the silicon nitride film portion) having an epitaxial relationship with the Si wafer and an Si epitaxial growth layer formed on the silicon nitride film by epitaxial growth were formed on the surface of the Si wafer. Note that elements in the film were analyzed regarding the silicon nitride film portion by TEM-EDX, and as a result, it was confirmed that Si and N were detected.

As described above, according to the Examples of the present invention, high-quality SOI wafers each having, on a surface of a silicon single crystal substrate, a silicon nitride film having an epitaxial relationship with the silicon single crystal substrate and an Si epitaxial growth layer formed were successfully obtained by a simple and highly productive method.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for manufacturing a semiconductor substrate by forming an insulator film and a semiconductor single crystal layer successively on a surface of a silicon single crystal substrate to manufacture a semiconductor substrate having the semiconductor single crystal layer on the insulator film, the method comprising at least the steps of:
forming a silicon nitride film having an epitaxial relationship with the silicon single crystal substrate on the surface of the silicon single crystal substrate as the insulator film by subjecting the silicon single crystal substrate to a heat treatment under a nitrogen gas-containing atmosphere; and
forming the semiconductor single crystal layer on the silicon nitride film by epitaxial growth.

2. The method for manufacturing a semiconductor substrate according to claim 1, wherein the heat treatment under the nitrogen gas-containing atmosphere is performed at a temperature of 800°C or higher.

3. The method for manufacturing a semiconductor substrate according to claim 1 or 2, wherein by using an epitaxial growth apparatus as an apparatus for performing the heat treatment, the silicon nitride film is formed, and then an atmospheric gas inside the epitaxial growth apparatus is switched to a gas for growing the semiconductor single crystal layer to perform the epitaxial growth.

4. The method for manufacturing a semiconductor substrate according to any one of claims 1 to 3, wherein the semiconductor single crystal layer is one of an Si layer, an SiGe layer, a Ge layer, or a compound semiconductor layer.

5. The method for manufacturing a semiconductor substrate according to claim 4, wherein the semiconductor single crystal layer is an Si layer, and a gas for the epitaxial growth of the Si layer is trichlorosilane.

6. The method for manufacturing a semiconductor substrate according to any one of claims 1 to 5, wherein the silicon nitride film has a film thickness of 2 nm or less.

7. The method for manufacturing a semiconductor substrate according to any one of claims 1 to 6, wherein a plurality of layers of the silicon nitride film and the semiconductor single crystal layer are formed alternately.

8. The method for manufacturing a semiconductor substrate according to any one of claims 1 to 7, wherein a silicon single crystal substrate doped with nitrogen or oxygen beforehand is used as the silicon single crystal substrate.

9. The method for manufacturing a semiconductor substrate according to any one of claims 1 to 8, wherein a silicon single crystal substrate having a plane orientation of (111) is used as the silicon single crystal substrate.

10. A semiconductor substrate having an insulator film and a semiconductor single crystal layer on the insulator film on a surface of a silicon single crystal substrate, wherein
the insulator film is a silicon nitride film having an epitaxial relationship with the silicon single crystal substrate and
the semiconductor single crystal layer is an epitaxial growth layer.

11. The semiconductor substrate according to claim 10, wherein the semiconductor single crystal layer is one of an Si layer, an SiGe layer, a Ge layer, or a compound semiconductor layer.

12. The semiconductor substrate according to claim 10 or 11, wherein the silicon nitride film has a film thickness of 2 nm or less.

13. The semiconductor substrate according to any one of claims 10 to 12, having a plurality of layers of the silicon nitride film and the semiconductor single crystal layer alternately.

14. The semiconductor substrate according to any one of claims 10 to 13, wherein the silicon single crystal substrate has a plane orientation of (111).
